(19) Europäisches Patentamt
European Patent Office
Office européen des brevets

(11) **EP 4 273 570 A1**

(12) **EUROPÄISCHE PATENTANMELDUNG**

(43) Veröffentlichungstag:
**08.11.2023   Patentblatt 2023/45**

(51) Internationale Patentklassifikation (IPC):
***G01R 33/565*** *(2006.01)*        ***G01R 33/56*** *(2006.01)*

(21) Anmeldenummer: **22171264.9**

(52) Gemeinsame Patentklassifikation (CPC):
**G01R 33/56572; G01R 33/5608; G06N 20/00;**
**G06N 3/02**

(22) Anmeldetag: **03.05.2022**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH**
**91052 Erlangen (DE)**

(72) Erfinder:
• **Puls, Philipp**
**91058 Erlangen (DE)**
• **Stich, Manuel**
**92711 Parkstein (DE)**

(54) **REDUZIEREN UND KORRIGIEREN VON MAGNETFELDGRADIENTEN-ABWEICHUNGEN**

(57)     Bei einem Verfahren zum Reduzieren und/oder Korrigieren von Abweichungen eines durch eine MR-Anlage (1) erzeugten Magnetfeldgradienten (32) von einem Ziel-Gradienten (31) werden Eingangsdaten für eine mittels eines Machine-Learning-Algorithmus trainierte Funktion bereitgestellt, wobei die Eingangsdaten eine Information über den Ziel-Gradienten der MR-Anlage (1) umfassen. Weiter erzeugt die trainierte Funktion anhand der Eingangsdaten Ausgangsdaten. Die Abweichungen des durch die MR-Anlage (1) erzeugten Magnetfeldgradienten (32) von dem Ziel-Gradienten (31) werden anhand der erzeugten Ausgangsdaten reduziert und/oder korrigiert.

FIG 3

EP 4 273 570 A1

**Beschreibung**

Die Erfindung betrifft ein Verfahren und eine Vorrichtung zum Reduzieren und/oder Korrigieren von Abweichungen eines durch eine Magnetresonanzanlage (MR-Anlage) erzeugten Magnetfeldgradienten von einem Ziel-Gradienten. Weiter betrifft die Erfindung ein Verfahren zum Erzeugen einer trainierten Funktion. Schließlich betrifft die Erfindung eine MR-Anlage.

Stand der Technik

Bei der Magnetresonanztomografie überlagern sich mehrere Magnetfelder. So wird zunächst ein hohes Hintergrundmagnetfeld erzeugt, welches dazu führt, dass sich die Kerne aufgrund ihres Kernspins entlang des Hintergrundmagnetfeldes ausrichten. Weiter wird mithilfe eines Gradientensystems ein Magnetfeldgradient erzeugt, welcher die ortsabhängige Magnetresonanzfrequenz (Larmor-Frequenz) festlegt. Ferner werden Hochfrequenz-Anregungen erzeugt, welche die Kernspins bestimmter, resonant angeregter Kerne mit einem Flipwinkel relativ zum Hintergrundmagnetfeld ausrichten. Bei bereits angeregten Kernspins können diese in eine andere Winkelstellung, und insbesondere in einem Ausgangszustand parallel zum Hintergrundmagnetfeld gebracht werden. Bei diesem als Relaxation bezeichneten Vorgang wird eine Hochfrequenzstrahlung erzeugt, welche gemessen wird. Dadurch werden die sogenannten Rohdaten erzeugt.

Die Magnetresonanzstrahlung wird im Ortsfrequenzraum ("k-Raum") aufgezeichnet. Durch Auswertung der Rohdaten können schließlich Bilddaten des zu untersuchenden Objekts erzeugt werden.

Während der Messung können speziell vorgegebene Pulssequenzen ausgesendet werden, wobei es sich um Abfolgen von Hochfrequenzpulsen und von Magnetfeldgradienten handelt.

Die Genauigkeit des verwendeten Gradientensystems hat einen großen Einfluss auf die Bildqualität. Insbesondere nichtkartesische Aufnahmen, z. B. mit radialen oder spiralförmigen Trajektorien oder Single-Shot-Echo-Planar-Imaging (EPI), stellen dabei hohe Anforderungen an die zeitliche Genauigkeit der Magnetfeldgradienten.

Aus mehreren Gründen kann es jedoch zu Abweichungen eines erzeugten (ausgespielten) Magnetfeldgradienten von einem Ziel-Gradienten (nominellen Magnetfeldgradienten) kommen. Wichtige Einflussfaktoren sind etwa Wirbelströme, Timing- und Verstärkerfehler sowie Feldfluktuationen, die durch mechanische Vibrationen beim Schalten von Magnetfeldgradienten verursacht werden. Weiter können thermische Schwankungen von Hardware-komponenten einen Einfluss haben, etwa von Gradientenspulen, von der Elektronik des Gradientenverstärkers oder dergleichen. All diese Effekte führen zu Abweichungen von dem gewünschten Ziel-Gradienten oder zu Fehlern im erfassten Signal und schließlich zu Artefakten im Bild.

Wenn diese Abweichungen genau bekannt sind, kann der tatsächliche Magnetfeldgradient bestimmt und zur Bildrekonstruktion verwendet werden. Alternativ kann der tatsächlich ausgespielte Magnetfeldgradient gemessen werden. Die ermittelten Abweichungen können aber auch zur Vorkompensation möglicher Abweichungen der Magnetfeldgradienten genutzt werden.

Das Verhalten des Gradientensystems ist dabei auch temperaturabhängig. Das Ausspielen eines Magnetfeldgradienten mit den Gradientenspulen führt zu einer Erwärmung des Systems. Diese Temperaturänderung beeinflusst wiederum das Übertragungsverhalten des dynamischen Gradientensystems.

Kleine Feldsonden oder eine dynamische Feldkamera können verwendet werden, um den ausgespielten Magnetfeldgradienten zu messen, welcher vom Ziel-Gradienten abweicht, wie in Duyn et al., "Simple correction method for k-space trajectory deviations in MRI", J. Magn. Reson. 1998, 132, Seiten 150-153, beschrieben. Der gemessene Magnetfeldgradient kann dann für die Bildrekonstruktion verwendet werden.

Eine mögliche Korrektur bei der Bildrekonstruktion wird beispielsweise beschrieben in Campbell-Washburn et al., "Realtime distortion correction of spiral and echo planar images using the gradient system impulse response function", Magn. Reson. Med., 75: 2278-2285, 2016.

Die Trajektorie muss dabei für die Rekonstruktion neu erfasst werden, wenn sich bestimmte Sequenz- oder Bildparameter ändern. Dies erschwert die Verwendung dieses Ansatzes in einem medizinischen Produkt in der täglichen klinischen Routine.

Es ist daher eine Aufgabe der vorliegenden Erfindung, eine in der klinischen Routine anwendbare Reduzierung bzw. Korrektur von Abweichungen eines durch eine MR-Anlage erzeugten Magnetfeldgradienten von einem Ziel-Gradienten bereitzustellen.

Zusammenfassung der Erfindung

Diese Aufgabe wird durch ein Verfahren und eine Vorrichtung zum Reduzieren und/oder Korrigieren von Abweichungen eines durch eine MR-Anlage erzeugten Magnetfeldgradienten von einem Ziel-Gradienten, durch ein Verfahren zum Erzeugen einer trainierten Funktion, und durch eine MR-Anlage mit den Merkmalen der unabhängigen Patentansprüche gelöst.

Bevorzugte Ausführungsformen sind Gegenstand der jeweiligen Unteransprüche.

Gemäß einem ersten Aspekt betrifft die Erfindung demnach ein Verfahren zum Reduzieren und/oder Korrigieren von Abweichungen eines durch eine MR-Anlage erzeugten Magnetfeldgradienten von einem Ziel-Gradienten. Eingangsdaten für eine mittels eines Machine-Learning-Algorithmus trainierte Funktion werden bereitgestellt, wobei die Eingangsdaten eine Information über den Ziel-Gradienten der MR-Anlage umfassen. Weiter erzeugt die trainierte Funktion anhand der Eingangsdaten Ausgangsdaten. Die Abweichungen des durch die MR-Anlage erzeugten Magnetfeldgradienten von dem Ziel-Gradienten werden anhand der erzeugten Ausgangsdaten reduziert und/oder korrigiert.

Gemäß einem zweiten Aspekt betrifft die Erfindung ein computerimplementiertes Verfahren zum Erzeugen einer trainierten Funktion. Dabei werden Trainingsdaten bereitgestellt, welche mindestens einen Ziel-Gradienten einer MR-Anlage mit zugehörigem tatsächlich durch die MR-Anlage erzeugtem Magnetfeldgradienten umfasst. Die Funktion wird mittels eines Machine-Learning-Algorithmus trainiert, basierend auf den Trainingsdaten. Die Funktion wird dazu trainiert, Ausgangsdaten auszugeben, welche zum Reduzieren und/oder Korrigieren von Abweichungen durch die MR-Anlage erzeugter Magnetfeldgradienten von Ziel-Gradienten verwendbar sind. Die trainierte Funktion wird bereitgestellt.

Gemäß einem dritten Aspekt betrifft die Erfindung eine Vorrichtung zum Reduzieren und/oder Korrigieren von Abweichungen eines durch eine MR-Anlage erzeugten Magnetfeldgradienten von einem Ziel-Gradienten. Die Vorrichtung umfasst eine Recheneinrichtung, welche dazu ausgebildet ist, einer mittels eines Machine-Learning-Algorithmus trainierten Funktion Eingangsdaten bereitzustellen, wobei die Eingangsdaten eine Information über den Ziel-Gradienten der MR-Anlage umfassen. Die Recheneinrichtung ist weiter dazu ausgebildet, mittels der trainierten Funktion anhand der Eingangsdaten Ausgangsdaten zu erzeugen. Die Vorrichtung umfasst weiter eine Reduzier-/Korrektureinrichtung, welche dazu ausgebildet ist, anhand der Ausgangsdaten der trainierten Funktion die Abweichungen des durch die MR-Anlage erzeugten Magnetfeldgradienten von dem Ziel-Gradienten zu reduzieren und/oder zu korrigieren. Gemäß einem vierten Aspekt betrifft die Erfindung eine MR-Anlage mit einem Verstärker, welcher dazu ausgebildet ist, ein Verstärker-Eingangssignal zu verstärken und als Verstärker-Ausgangssignal auszugeben. Die MR-Anlage umfasst weiter eine Gradientenspule, welche dazu ausgebildet ist, anhand des Verstärker-Ausgangssignals einen Magnetfeldgradienten zu erzeugen. Schließlich umfasst die MR-Anlage eine erfindungsgemäße Vorrichtung gemäß dem dritten Aspekt, welche dazu ausgebildet ist, Abweichungen des durch die Gradientenspulen erzeugten Magnetfeldgradienten von einem Ziel-Gradienten zu korrigieren und/oder zu reduzieren.

Gemäß einem fünften Aspekt betrifft die Erfindung ein Computerprogrammprodukt mit ausführbarem Programmcode, welcher dazu ausgebildet ist, beim Ausführen auf einer Steuervorrichtung der MR-Anlage gemäß dem vierten Aspekt das erfindungsgemäße Verfahren zum Reduzieren und/oder Korrigieren von Abweichungen eines durch die MR-Anlage erzeugten Magnetfeldgradienten von einem Ziel-Gradienten gemäß dem ersten Aspekt oder das erfindungsgemäße Verfahren zum Erzeugen einer trainierten Funktion gemäß dem zweiten Aspekt auszuführen.

Gemäß einem sechsten Aspekt betrifft die Erfindung ein nichtflüchtiges, computerlesbares Speichermedium mit ausführbarem Programmcode, welcher dazu ausgebildet ist, beim Ausführen auf einer Steuervorrichtung der erfindungsgemäßen MR-Anlage gemäß dem vierten Aspekt das Verfahren zum Reduzieren und/oder Korrigieren von Abweichungen eines durch die MR-Anlage erzeugten Magnetfeldgradienten von einem Ziel-Gradienten gemäß dem ersten Aspekt oder das erfindungsgemäße Verfahren zum Erzeugen einer trainierten Funktion gemäß dem zweiten Aspekt auszuführen.

Das Reduzieren und/oder Korrigieren der Abweichungen des durch die MR-Anlage erzeugten Magnetfeldgradienten von dem Ziel-Gradienten erfolgt erfindungsgemäß unter Verwendung einer trainierten Funktion (d.h. einem trainierten Algorithmus). Dadurch kann vorteilhaft angenommen werden, dass der Verstärker und die Gradientenspule der MR-Anlage ein im Wesentlichen lineares und/oder zeitinvariantes Verhalten aufweisen. Die trainierte Funktion ist dabei gut geeignet, um mit diesen Nichtlinearitäten umzugehen.

Die Erfindung kann eine einfache und schnell durchzuführende und/oder genaue Methode zur Korrektur von Störeffekten bereitstellen. Die trainierte Funktion eignet sich insbesondere dazu, während einer Magnetresonanzmessung eines Patienten angewendet zu werden, so dass zeitaufwändige und/oder rechenintensive Nachkorrekturverfahren vermieden werden können.

Unter einem Ziel-Gradienten wird im Sinne dieser Erfindung ein gewünschter Magnetfeldgradient (nomineller Magnetfeldgradient) verstanden, welcher sich von dem tatsächlich ausgespielten Magnetfeldgradienten unterscheiden kann.

Bei einer weiteren Ausführungsform des Verfahrens zum Reduzieren und/oder Korrigieren von Abweichungen eines durch eine MR-Anlage erzeugten Magnetfeldgradienten von einem Ziel-Gradienten umfasst die MR-Anlage einen Verstärker, welcher ein Verstärker-Eingangssignal verstärkt und als Verstärker-Ausgangssignal ausgibt. Die MR-Anlage umfasst eine Gradientenspule, welche anhand des Verstärker-Ausgangssignals den Magnetfeldgradienten erzeugt. Die trainierte Funktion ermittelt ein korrigiertes Verstärker-Eingangssignal oder ein Korrektursignal zum Korrigieren des Verstärker-Eingangssignals. Das Verstärker-Ausgangssignal wird in Abhängigkeit des korrigierten Verstärker-Eingangssignals oder des Korrektursignals erzeugt. Die trainierte Funktion kann somit gemäß einer Ausführungsform das Verstärker-Eingangssignal direkt erzeugen. Alternativ kann ein Korrektursignal erzeugt werden, welches mit einem von einer Steuereinrichtung erzeugten Verstärker-Eingangssignal kombiniert werden kann. Hierzu kann das Kombinieren durch zumindest eines von Faktorisieren, Subtrahieren, Wichten und Potenzieren erfolgen. Das elektrische Eingangssignal kann dabei entsprechend angepasst werden.

Durch das Verwenden des korrigierten Verstärker-Eingangssignals oder des Korrektursignals kann eine Vorkorrektur durchgeführt werden, sodass die Abweichungen des durch die MR-Anlage erzeugten Magnetfeldgradienten von dem Ziel-Gradienten vorteilhaft reduziert werden können.

Bei einer weiteren Ausführungsform des Verfahrens zum Reduzieren und/oder Korrigieren von Abweichungen eines durch eine MR-Anlage erzeugten Magnetfeldgradienten von einem Ziel-Gradienten ermittelt die trainierte Funktion eine Schätzung für einen von der MR-Anlage erzeugten Magnetfeldgradienten. Diese Informationen können bei einer Auswertung von aufgenommenen Messdaten berücksichtigt werden, z. B. im Rahmen eines Nachkorrekturverfahrens. Dies kann beispielsweise eine Korrektur des Einflusses der Abweichung von dem Ziel-Gradienten in den Bilddaten bei der Bildrekonstruktion umfassen, wie beispielsweise beschrieben in Campbell-Washburn et al., "Real-time distortion correction of spiral and echo planar images using the gradient system impulse response function".

Es kann vorgesehen sein, dass die trainierte Funktion dazu trainiert ist, die Abweichung z.B. anhand des Eingangssignals bzw. Ziel-Gradienten zu ermitteln oder zu schätzen. Anstelle oder zusätzlich zu der Pre-Emphasis, d.h. zu Maßnahmen zur Korrektur des Verstärker-Ausgangssignals, kann ein entsprechendes Nachkorrekturverfahren (Post-Processing) erfolgen.

Bei einer weiteren Ausführungsform des Verfahrens zum Reduzieren und/oder Korrigieren von Abweichungen eines durch eine MR-Anlage erzeugten Magnetfeldgradienten von einem Ziel-Gradienten wird anhand der Schätzung für den von der MR-Anlage erzeugten Magnetfeldgradienten eine Gradientencharakterisierungsfunktion ermittelt. Die Gradientencharakterisierungsfunktion kann insbesondere eine Gradientensystem-Übertragungsfunktion (GSTF) umfassen.

Bei einer weiteren Ausführungsform des Verfahrens zum Reduzieren und/oder Korrigieren von Abweichungen eines durch eine MR-Anlage erzeugten Magnetfeldgradienten von einem Ziel-Gradienten wird anhand der Gradientencharakterisierungsfunktion ein korrigiertes Verstärker-Eingangssignal oder ein Korrektursignal zum Korrigieren des Verstärker-Eingangssignals erzeugt. Das korrigierte Verstärker-Eingangssignal wird an den Verstärker angelegt. Die Gradientencharakterisierungsfunktion kann somit für eine Vorkorrektur (englisch: pre-emphasis) verwendet werden.

Bei einer weiteren Ausführungsform des Verfahrens zum Reduzieren und/oder Korrigieren von Abweichungen eines durch eine MR-Anlage erzeugten Magnetfeldgradienten von einem Ziel-Gradienten erzeugt die MR-Anlage mittels des erzeugten Magnetfeldgradienten Rohdaten. Anhand der Rohdaten und der Gradientencharakterisierungsfunktion werden MR-Bilddaten erzeugt. Die Gradientencharakterisierungsfunktion kann somit für ein Nachkorrekturverfahren (englisch: post-correction) verwendet werden.

Bei einer weiteren Ausführungsform des Verfahrens zum Reduzieren und/oder Korrigieren von Abweichungen eines durch eine MR-Anlage erzeugten Magnetfeldgradienten von einem Ziel-Gradienten umfassen die Eingangsdaten für die trainierte Funktion weiter ein Verstärker-Eingangssignal eines Verstärkers der MR-Anlage, wobei der Verstärker das Verstärker-Eingangssignal verstärkt und als Verstärker-Ausgangssignal an eine Gradientenspule der MR-Anlage ausgibt, welche anhand des Verstärker-Ausgangssignals einen Magnetfeldgradienten erzeugt. Weiter können die Eingangsdaten zusätzlich oder alternativ das gemessene Verstärker-Ausgangssignal umfassen. Weiter können die Eingangsdaten zusätzlich oder alternativ mindestens eine gemessene Temperatur des Verstärkers und/oder einer Gradientenspule umfassen. Weiter können die Eingangsdaten zusätzlich oder alternativ einen gemessenen von der MR-Anlage erzeugten Magnetfeldgradienten umfassen. Weiter können die Eingangsdaten zusätzlich oder alternativ einen Bildgebungsbereich, insbesondere eine diagnostisch relevante Körperregion eines Patienten, umfassen. Weiter können die Eingangsdaten zusätzlich oder alternativ eine Information bezüglich eines durch die MR-Anlage untersuchten Objekts umfassen. Dabei kann es sich insbesondere um Patienteninformationen handeln, wie z. B. Größe, Gewicht, Geschlecht oder Alter des untersuchten Patienten. Der Körper des untersuchten Patienten kann dabei einen Einfluss auf den ausgespielten Magnetfeldgradienten haben. So kann es etwa zu Verzerrungen kommen. Solche Einflüsse können der trainierten Funktion eintrainiert werden, sodass diese derartige Einflüsse kompensieren kann. Durch Berücksichtigung dieser zusätzlichen Eingangsdaten kann das Reduzieren und/oder Korrigieren der Abweichungen nochmals verbessert werden.

Bei einer weiteren Ausführungsform des computerimplementierten Verfahrens zum Erzeugen der trainierten Funktion wird die trainierte Funktion derart erzeugt, dass anhand der trainierten Funktion eine Schätzung für einen von der MR-Anlage erzeugten Magnetfeldgradienten ermittelt werden kann, wobei anhand der Schätzung für den von der MR-Anlage erzeugten Magnetfeldgradienten eine Gradientencharakterisierungsfunktion ermittelt werden kann. Die trainierte Funktion kann auch die Schätzung für den von der MR-Anlage erzeugten Magnetfeldgradienten selbst erzeugen und ausgeben.

Die trainierte Funktion kann weiter derart erzeugt werden, dass anhand der Gradientencharakterisierungsfunktion ein korrigiertes Verstärker-Eingangssignal oder ein Korrektursignal zum Korrigieren des Verstärker-Eingangssignals erzeugt werden kann, d.h. für die oben beschriebene Vorkorrektur. Alternativ kann die trainierte Funktion derart erzeugt werden, dass anhand von Rohdaten, welche von der MR-Anlage mittels des erzeugten Magnetfeldgradienten erzeugt werden, und anhand der Gradientencharakterisierungsfunktion MR-Bilddaten erzeugt werden können, d.h. für das oben beschriebene Nachkorrekturverfahren.

Bei einer weiteren Ausführungsform des computerimplementierten Verfahrens zum Erzeugen der trainierten Funktion umfasst ein Zeitverlauf der Ziel-Gradienten zumindest eines von einem rechteckigen Verlauf, einem trapezförmigen Verlauf und einem Chirp-Puls.

Bei einer weiteren Ausführungsform des computerimplementierten Verfahrens zum Erzeugen der trainierten Funktion umfassen die Trainingsdaten eine Information über den Ziel-Gradienten der MR-Anlage und zugehörige tatsächlich durch die MR-Anlage erzeugte Magnetfeldgradienten für eine Vielzahl unterschiedlicher Temperaturen von mindestens einer Komponente der MR-Anlage, und/oder unterschiedlicher Frequenzen, unterschiedlicher Pulsweiten, unterschiedlicher Amplituden und/oder unterschiedlicher Flankensteilheiten von Magnetfeldgradienten. Die Magnetfeldgradienten sind über ihre Gradientenamplitude, die Gradientenpulszeitdauer und über die Flankensteilheit bzw. die erste Ableitung der Pulsform dG/dt der Magnetfeldgradienten, üblicherweise auch als "Slew Rate" (Flankensteilheit) bezeichnet, definiert. Somit können der trainierten Funktion verschiedene Magnetfeldgradienten und/oder Randbedingungen eines Magnetfeldgradienten eintrainiert werden. Mögliche Randbedingungen umfassen etwa eine Temperatur (etwa eine Temperatur eines Gradienten oder eine Umgebungstemperatur), die Dauer eines Magnetfeldgradienten und/oder die Dauer und/oder Abfolge einer Pulssequenz von Magnetfeldgradienten.

Bei einer weiteren Ausführungsform des computerimplementierten Verfahrens zum Erzeugen der trainierten Funktion umfassen die Trainingsdaten für ein Paar aus einem Ziel-Gradienten und einem zugehörigen tatsächlich durch die MR-Anlage erzeugten Magnetfeldgradienten weiter mindestens eines von

- einem Verstärker-Eingangssignal eines Verstärkers der MR-Anlage, wobei der Verstärker das Verstärker-Eingangssignal verstärkt und als Verstärker-Ausgangssignal an Gradientenspulen der MR-Anlage ausgibt, welche anhand des Verstärker-Ausgangssignals einen Magnetfeldgradienten erzeugen,
- dem Verstärker-Ausgangssignal,
- mindestens einer gemessenen Temperatur des Verstärkers und/oder der Gradientenspulen,
- einem gemessenen von der MR-Anlage erzeugten Magnetfeldgradienten,
- einem Bildgebungsbereich, und
- eine Information bezüglich eines durch die MR-Anlage untersuchten Objekts.

Bei einer weiteren Ausführungsform des computerimplementierten Verfahrens zum Erzeugen der trainierten Funktion basiert die trainierte Funktion auf einem künstlichen neuronalen Netzwerk. Ein neuronales Netz kann insbesondere ein tiefes neuronales Netz, ein faltungsbasiertes neuronales Netz oder ein faltungsbasiertes tiefes neuronales Netz sein. Darüber hinaus kann ein neuronales Netz ein adversariales Netz, ein tiefes adversariales Netz und/oder ein generatives adversariales Netz sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:

Fig. 1    ein schematisches Blockdiagramm einer MR-Anlage mit einer Vorrichtung zum Reduzieren und/oder Korrigieren von Abweichungen eines durch die MR-Anlage erzeugten Magnetfeldgradienten von einem ZielGradienten gemäß einer Ausführungsform der Erfindung;

Fig. 2    eine schematische Ansicht einer MR-Anlage zur Erläuterung des Auftretens der Abweichungen eines durch die MR-Anlage erzeugten Magnetfeldgradienten von einem Ziel-Gradienten;

Fig. 3    eine schematische Darstellung zur Erläuterung der Berechnung einer Gradientencharakterisierungsfunktion;

Fig. 4    beispielhafte Zeitverläufe von Testpulsen;

Fig. 5    eine beispielhafte Abweichung von einem durch eine MR-Anlage erzeugten Magnetfeldgradienten von dem in Figur 4 gezeigten dreieckförmigen Zeitverlauf des Ziel-Gradienten;

Fig. 6    eine beispielhafte Abweichung von einem durch eine MR-Anlage erzeugten Magnetfeldgradienten von dem in Figur 4 gezeigten Chirp-Puls-artigen Zeitverlauf des Ziel-Gradienten;

Fig. 7     ein schematisches Blockdiagramm zur Erläuterung der Verwendung einer trainierten Funktion zum Reduzieren und/oder Korrigieren von Abweichungen eines durch eine MR-Anlage erzeugten Magnetfeldgradienten von einem Ziel-Gradienten gemäß einer Ausführungsform der Erfindung;

Fig. 8     ein schematisches Blockdiagramm zur Erläuterung der Verwendung einer trainierten Funktion zum Reduzieren und/oder Korrigieren von Abweichungen eines durch eine MR-Anlage erzeugten Magnetfeldgradienten von einem Ziel-Gradienten gemäß einer weiteren Ausführungsform der Erfindung;

Fig. 9     beispielhafte Darstellungen der Reduktion und/oder Korrektur von Abweichungen eines durch eine MRAnlage erzeugten Magnetfeldgradienten von einem Ziel-Gradienten für einen spezifischen Zeitverlauf des Ziel-Gradienten;

Fig. 10    ein Flussdiagramm eines Verfahrens zum Reduzieren und/oder Korrigieren von Abweichungen eines durch eine MR-Anlage erzeugten Magnetfeldgradienten von einem Ziel-Gradienten gemäß einer Ausführungsform der Erfindung;

Fig. 11    ein Flussdiagramm eines computerimplementierten Verfahrens zum Erzeugen einer trainierten Funktion gemäß einer Ausführungsform der Erfindung;

Fig. 12    ein schematisches Blockdiagramm eines Computerprogrammprodukts gemäß einer Ausführungsform der Erfindung; und

Fig. 13    ein schematisches Blockdiagramm eines nichtflüchtigen, computerlesbaren Speichermediums gemäß einer Ausführungsform der Erfindung.

Detaillierte Figurenbeschreibung

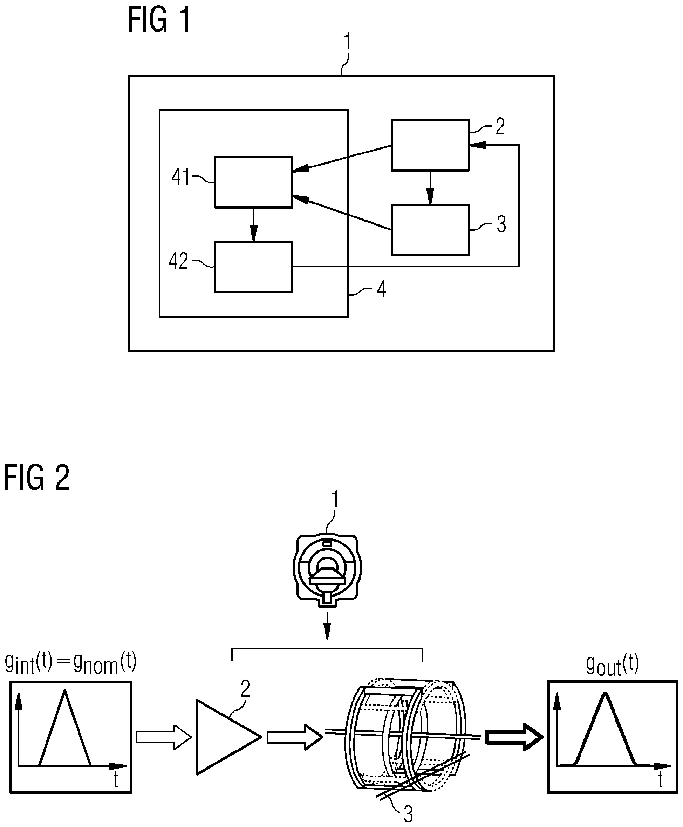

Figur 1 zeigt ein schematisches Blockdiagramm einer Ausführungsform einer Magnetresonanzanlage 1 mit einer Vorrichtung 4 zum Reduzieren und/oder Korrigieren von Abweichungen eines durch die MR-Anlage 1 erzeugten Magnetfeldgradienten von einem Ziel-Gradienten.

Die MR-Anlage 1 umfasst dabei einen Verstärker 2, welcher ein Verstärker-Eingangssignal verstärkt und als Verstärker-Ausgangssignal ausgibt. Weiter umfasst die MR-Anlage 1 eine Gradientenspule 3, welche anhand des Verstärker-Ausgangssignals einen Magnetfeldgradienten erzeugt. Gemäß weiteren Ausführungsformen kann die MR-Anlage 1 eine Vielzahl von Gradientenspulen 3 aufweisen.

Die Vorrichtung 4 umfasst eine Recheneinrichtung 41. Diese ist dazu ausgebildet, einer mittels eines Machine-Learning-Algorithmus trainierten Funktion Eingangsdaten bereitzustellen. Die Eingangsdaten umfassen eine Information über den Ziel-Gradienten der MR-Anlage 1. Bei der Information über den Ziel-Gradienten kann es sich insbesondere um eine Bezeichnung des Ziel-Gradienten, das Verstärker-Eingangssignal, oder Verstärker-Ausgangssignal oder dergleichen handeln. Es ist ebenso vorstellbar, dass die Information über den Ziel-Gradienten einen zeitlichen Verlauf des Ziel-Gradienten, eine Frequenz des Ziel-Gradienten, eine Pulsweite des Ziel-Gradienten und/oder eine Flankensteilheit des Ziel-Gradienten umfasst. Die Bezeichnung des Ziel-Gradienten kann beispielsweise ein numerischer Wert, ein String (z.B. ein Codename oder Akronym) oder ein Bezeichner in einem beliebigen Datenformat sein.

Die Eingangsdaten für die trainierte Funktion können weiter beispielsweise ein Verstärker-Eingangssignal des Verstärkers 2 umfassen. Weiter können die Eingangsdaten das gemessene Verstärker-Ausgangssignal umfassen.

Eine Berücksichtigung von Temperaturabhängigkeiten ist ebenfalls möglich. Dazu können die Eingangsdaten mindestens eine gemessene Temperatur des Verstärkers 2 und/oder der Gradientenspule 3 umfassen. Dadurch wird eine Abhängigkeit von der Temperatur des Verstärkers 2 bzw. der Gradientenspule 3 der trainierten Funktion eintrainiert.

Die Eingangsdaten können weiter einen gemessenen, von der MR-Anlage 1 erzeugten Magnetfeldgradienten umfassen. Weiter kann ein Bildgebungsbereich umfasst sein, insbesondere eine diagnostisch relevante Körperregion eines Patienten. Der Bildgebungsbereich kann insbesondere durch eine diagnostisch relevante Körperregion eines zu untersuchenden Patienten charakterisiert sein. Die diagnostisch relevante Körperregion kann beispielsweise eine relative Positionierung des Patienten zu der MR-Anlage 1 während einer Magnetresonanzuntersuchung bzw. eines Scans vorgeben oder bestimmen. Die relative Positionierung des Patienten zu der MR-Anlage 1 kann wiederum einen Einfluss auf den ausgespielten Magnetfeldgradienten (z. B. eine Verzerrung) besitzen, welcher der trainierten Funktion eintrainiert werden kann. Eine Information bezüglich eines durch die MR-Anlage 1 untersuchten Objekts kann ebenfalls Teil der Eingangsdaten sein. Dabei kann es sich insbesondere um Patienteninformationen handeln.

Die trainierte Funktion erzeugt anhand der Eingangsdaten Ausgangsdaten. Die Vorrichtung 4 umfasst weiter eine Reduzier-/Korrektureinrichtung 42, welche anhand der Ausgangsdaten der trainierten Funktion 81 die Abweichungen des durch die MR-Anlage 1 erzeugten Magnetfeldgradienten von dem Ziel-Gradienten reduziert und/oder korrigiert.

Die Vorrichtung 4 kann Software- und/oder Hardwarekomponenten umfassen, etwa CPUs (englisch: central processing unit), GPUs (englisch: graphics processing unit), Mikrocontroller, ICs (englisch: integrated circuits), ASICs (englisch: application-specific integrated circuits), FPGAs (englisch: field programmable gate array), programmierbare logische Schaltungen (PLDs), digitale Signalprozessoren (DSPs) oder dergleichen. Einzelne Einheiten der Vorrichtung 4, so die Recheneinrichtung 41 und die Reduzier-/Korrektureinrichtung 42, können als dieselbe Hardware-Komponente und/oder Software-Komponente oder als separate Hardware-Komponenten und/oder Software-Komponenten ausgeführt sein. Zumindest Teile der Berechnungen können auch auf einem entfernten Server, d. h. etwa in einer Cloud durchgeführt werden.

Die trainierte Funktion kann gemäß einer Ausführungsform ein korrigiertes Verstärker-Eingangssignal oder ein Korrektursignal zum Korrigieren des Verstärker-Eingangssignals ermitteln. Das Verstärker-Eingangssignal kann in Abhängigkeit des korrigierten Verstärker-Eingangssignals oder des Korrektursignals erzeugt werden. Die trainierte Funktion kann somit in einem Vorkorrektur-Szenario (englisch: Pre-Emphasis) verwendet werden und zeit- und/oder rechenintensive Nachkorrekturschritte, z. B. die Berechnung einer GSTF oder die Bildrekonstruktion in Abhängigkeit von der GSTF, können vermieden werden. Diese Vorkorrektur kann vorteilhaft für Gradientenpulse und/oder Gradienten-Pulssequenzen eingesetzt werden, die während einer Magnetresonanzuntersuchung oder eines Scans eines Patienten angewendet werden.

Die Reduzier-/Korrektureinrichtung 42 kann ausgebildet sein, das Verstärker-Eingangssignal mittels einer Schaltung, wie z. B. ASIC, PLD, FPGA, oder DSP, zu korrigieren bzw. an den Verstärker 2 zu übermitteln.

Figur 2 zeigt eine schematische Ansicht einer MR-Anlage 1 zur Erläuterung des Auftretens der Abweichungen eines durch die MR-Anlage 1 erzeugten Magnetfeldgradienten $g_{out}(t)$ von einem Ziel-Gradienten $gin(t) = g_{nom}(t)$.

Gemäß weiteren Ausführungsformen kann die trainierte Funktion eine Schätzung für einen von der MR-Anlage 1 erzeugten (ausgespielten) Magnetfeldgradienten ermitteln. Dabei kann beispielsweise eine Form und/oder Gestalt und/oder ein zeitlicher Verlauf eines Magnetfeldgradienten geschätzt werden, also z.B. in Form zeitabhängiger Werte. Anhand der Schätzung für den von der MR-Anlage 1 erzeugten Magnetfeldgradienten kann eine Gradientencharakterisierungsfunktion ermittelt werden.

Dabei kann die trainierte Funktion diverse Randbedingungen berücksichtigen, etwa Gradientenformen, Temperaturabhängigkeiten, Gradientenstärken (z.B. gemessen in Millitesla pro Meter) oder dergleichen.

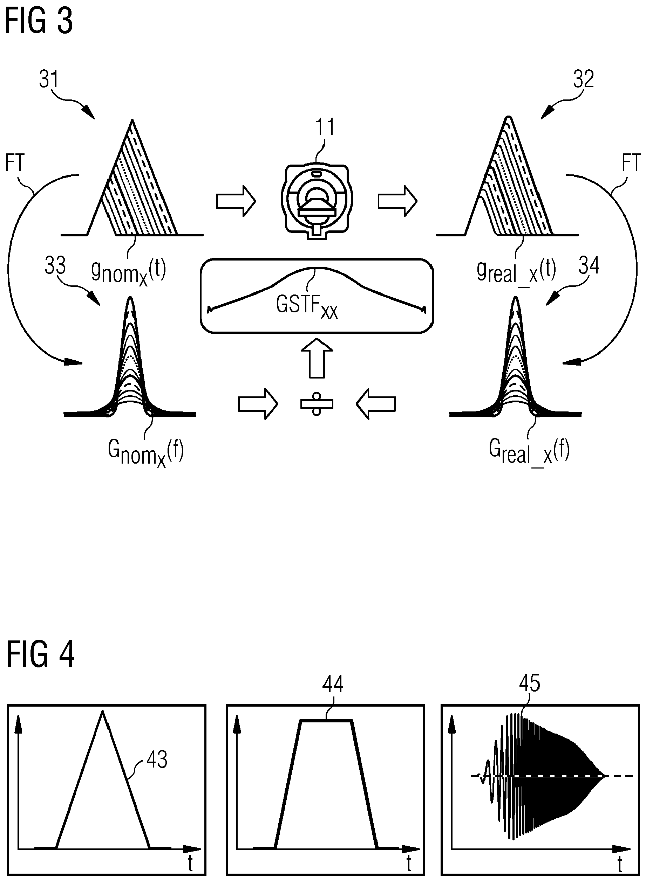

Figur 3 zeigt eine schematische Darstellung zur Erläuterung der Berechnung einer Gradientencharakterisierungsfunktion. Dabei sind verschiedene Zeitverläufe 31 nomineller Gradienten $g_{nom\_x}(t)$, d.h. von Ziel-Gradienten, sowie die zugehörigen Zeitverläufe 32 der tatsächlich ausgespielten Magnetfeldgradienten $g_{real\_x}(t)$ illustriert. Der nominelle Magnetfeldgradient $g_{nom\_x}(t)$, welcher in Figur 3 beispielhaft eine Dreiecksform aufweist, wird dabei von einer Steuereinrichtung der MR-Anlage 1 erzeugt und an einen Scanner 11 der MR-Anlage 1 übermittelt. Der tatsächlich ausgespielte Magnetfeldgradient $g_{real\_x}(t)$ weist aufgrund von Störeffekten Abweichungen von der Dreiecksform auf. Insbesondere sind die Ecken etwas abgerundet im Vergleich zum nominellen Magnetfeldgradienten $g_{nom\_x}(t)$.

Im unteren Teil der Figur 3 sind die durch eine Fouriertransformation FT erhaltenen Frequenzspektren 33, 34 der nominellen Magnetfeldgradienten $G_{nom\_x}(f)$ sowie die zugehörigen, ausgespielten Magnetfeldgradienten $G_{real\_x}(f)$ aufgetragen. Anhand der Frequenzspektren $G_{nom\_x}(f)$ sowie $G_{real\_x}(f)$ kann eine Gradientencharakterisierungsfunktion $GSTF_{xx}$ berechnet werden. Diese soll im Folgenden genauer erläutert werden.

Die Gradienten-Impulsantwortfunktion (GIRF) oder ihre Fourier-Transformation, die Gradientensystem-Übertragungsfunktion (GSTF) sind Gradientencharakterisierungsfunktionen, welche die Übertragungseigenschaften der MR-Anlage 1 vereinfachend beschreiben und die Korrektur von verzerrten Trajektorien aufgrund von Unzulänglichkeiten des Gradientensystems ermöglichen. Mathematisch lässt sich die Beziehung zwischen GIRF und GSTF wie folgt beschreiben:

$$\mathrm{GIRF} = \mathrm{FT}^{-1}\,\mathrm{GSTF},$$

wobei FT$^{-1}$ die inverse Fourier-Transformation bezeichnet.

Das MR-Bildgebungssystem wird mit Test-Magnetfeldgradienten (d.h. Testsignalen bzw. Eingangs-Magnetfeldgradienten), z. B. Rechteckpulsen, Dreieckspulsen oder Chirp-Pulsen, getestet. Dazu wird ein Ausgangs-Magnetfeldgradient für verschiedene Test-Magnetfeldgradienten gemessen. Dies geschieht durch Messung in einem bestimmten Messobjekt, z. B. einem Phantom (beim Dünnschichtverfahren) oder einer dynamischen Feldkamera. Die GSTF erster Ordnung kann beispielhaft für die x-Gradientenachse (k=l=x) als Summe des Ausgangsgradienten $G_{out}^{i}(f)$

geteilt durch die Summe der Eingangsgradienten $G^i_{nom}(f)$ berechnet werden:

$$GSTF_{k,l}(f) = \frac{\sum_{i=1}^{i=N} G_{in}^{*i}{}_k(f) \cdot G_{out}{}_l^i(f)}{\sum_{i=1}^{i=N}\left|G_{in}{}_k^i(f)\right|^2}.\Bigg|$$

Diese Beziehung beschreibt das Verhalten des Gradientensystems, also des Verstärkers und der Gradientenspule(n), jedoch nicht exakt. Ein möglicher Grund für Abweichungen kann z. B. ein nicht-lineares Verhalten und/oder eine zeitliche Änderung des Verhaltens (z. B. infolge von Alterungseffekten) insbesondere von elektronischen Komponenten des Verstärkers darstellen.

Solche Abweichungen können durch die Verwendung der trainierten Funktion berücksichtigt und kompensiert werden.

Die trainierte Funktion kann dazu trainiert sein, die GSTF direkt zu bestimmen, z. B. mittels Anlernens an Eingangsdaten und der berechneten GSTF. Somit erfolgt die Bestimmung der GSTF durch die trainierte Funktion. Durch die trainierte Funktion kann die GSTF schnell ermittelt werden und eine Berücksichtigung von Randbedingungen, wie z.B. des Temperatureinflusses oder des Einflusses durch den Patienten, wird erleichtert.

In einer weiteren Ausführungsform wird die GSTF anhand des durch die trainierte Funktion geschätzten Magnetfeldgradienten ermittelt. Dadurch ist keine Feldkamera zur Messung des Magnetfeldgradienten mehr erforderlich. Weiter kann dadurch ein Lernen der trainierten Funktion im medizinischen Betrieb erheblich erleichtert werden.

In einer Ausführungsform schätzt die trainierte Funktion die Gradientencharakterisierungsfunktion und kann auch nichtlineares Verhalten, zeitliche bedingte Änderungen und/oder Alterungseffekte einlernen.

Anhand der Gradientencharakterisierungsfunktion kann dann ein korrigiertes Verstärker-Eingangssignal oder ein Korrektursignal zum Korrigieren des Verstärker-Eingangssignals erzeugt werden. Das korrigierte Verstärker-Eingangssignal wird dann an den Verstärker 2 angelegt. Es handelt sich dabei um eine Vorkorrektur (englisch: pre-emphasis), d.h. die Korrektur erfolgt bereits auf der Ebene des erzeugten Verstärker-Eingangssignals und nicht erst durch Korrektur der bereits erzeugten Daten.

Die Vorkorrektur ist besonders vorteilhaft, da der Ziel-Gradientenpuls am Ausgang des Gradientensystems bzw. der Gradientenspule 3 erhalten wird. Bei bestimmten Sequenzen und Impulstypen kann nur eine Vorkorrektur zur Korrektur von Abweichungen der Magnetfeldgradienten dienen.

Das Korrektursignal kann im Sinne eines Regelungsverfahrens erzeugt werden, d. h. mit einem bereits erzeugten Verstärker-Eingangssignal kombiniert werden, um Abweichungen zu kompensieren. Durch die Vorkorrektur werden die Abweichungen vorzugsweise derart korrigiert, dass der tatsächlich erzeugte Magnetfeldgradient dem Ziel-Gradienten möglichst gut entspricht.

Das Gradientensystem mit der Gradientenspule 3 kann einen digitalen Signalprozessor (DSP), ein Field Programmable Gate Array (FPGA) oder eine ähnliche Einheit umfassen, die so konfiguriert ist, dass sie das Verstärker-Eingangssignal in Echtzeit anpasst.

Nachkorrekturverfahren (englisch: post-correction) sind ebenfalls möglich. Hierbei wird bevorzugt die GSTF verwendet, um Bildverzerrungen während der Bildrekonstruktion zu korrigieren.

Figur 4 zeigt beispielhafte Zeitverläufe von Testpulsen, welche zum Trainieren der Funktion verwendet werden können. Die Testpulse sind dabei Magnetfeldgradienten, welche zum Trainieren der trainierten Funktion verwendet werden können. Die Testpulse können dabei auch Magnetfeldgradienten im regulären medizinischen Betrieb sein.

Unterschiedliche Sätze von Testpulsen können dazu dienen, eine allgemeine Darstellung beliebiger Abbildungspulse zu trainieren. Für diese Testpulse können beispielsweise Dreieckspulse 43, Rechteckpulse bzw. Trapezpulse 44 und Chirp-Pulse 45 verwendet werden. Dabei können Parametersätze variiert werden, etwa Pulsbreite, Amplitude und Flankensteilheit. Vorzugsweise wird ein breites Frequenzspektrum (beispielsweise 0-100 kHz) mit einer hohen spektralen Intensität abgedeckt. Mit dieser Auswahl an Testpulsen kann sichergestellt werden, dass der trainierte Algorithmus lernt, wie die MR-Anlage 1 die verschiedenen Frequenzkomponenten überträgt, aus denen sich alle konventionell verwendeten Bildgebungsgradienten zusammensetzen. Idealerweise werden alle möglichen Frequenzen, die von übertragen werden können, getestet.

In einer Ausführungsform enthält der Trainingsdatensatz viele Paare von nominellen und real ausgespielten (verzerrten) Magnetfeldgradienten unter verschiedenen Randbedingungen, wie z. B. verschiedene Temperaturen, aber auch verschiedene Dauern und/oder Abfolgen von Magnetfeldgradienten.

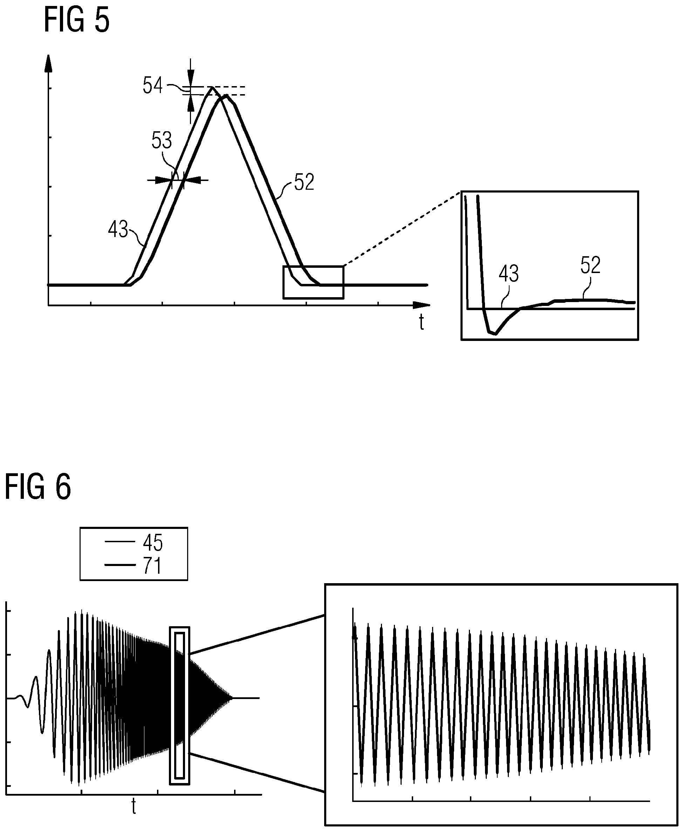

Figur 5 zeigt eine beispielhafte Abweichung von einem durch eine MR-Anlage 1 erzeugten Magnetfeldgradienten 52 von dem auch in Figur 4 gezeigten dreieckförmigen Zeitverlauf des Ziel-Gradienten 43. Dabei tritt eine Signalübertragungsreduktion 54 auf. Weiter gibt es eine Signalverzögerung 53.

Figur 6 zeigt eine beispielhafte Abweichung eines durch eine MR-Anlage 1 erzeugten Magnetfeldgradienten 71 von dem in Figur 4 gezeigten Chirp-Puls-artigen Zeitverlauf des Ziel-Gradienten 45.

Während der Bildgebung können sich der Verstärker 2 und die Gradientenspule 3 erwärmen, insbesondere wenn längere Arbeitszyklen und/oder hohe Flankensteilheiten verwendet werden. Der Temperaturzustand in der Gradientenspule 3 und/oder dem Verstärker 2 kann durch verschiedene Temperatursensoren gemessen werden, die vorzugsweise in das Gradientensystem integriert sind. Alternativ können der Temperaturzustand bzw. Temperaturänderungen auch durch den komplexen Widerstand des Systems modelliert werden. Vorzugsweise werden die Temperaturzustände in den Trainingsdatensatz aufgenommen, z.B. durch Ausspielen von Bildgradienten bei verschiedenen Temperaturzuständen.

In einigen Ausführungsformen können die Trainingsdaten auch das Verstärkereingangssignal $i_{in}$, das Verstärkerausgangssignal $i_{out}$, aber auch Informationen über die diagnostisch relevante Körperregion des Patienten sowie den Patienten selbst, die das magnetische Gradientenfeld des ausgespielten Magnetfeldgradienten stören und damit Störeffekte einführen können, enthalten. Weiter kann vorgesehen sein, dass die trainierte Funktion Zugang zu Echtzeit-Messwerten (oder berechneten Werten) dieser Parameter hat, um eine Echtzeit- oder Vorab-Kompensation von Störeffekten während einer MR-Messung eines Patienten zu ermöglichen.

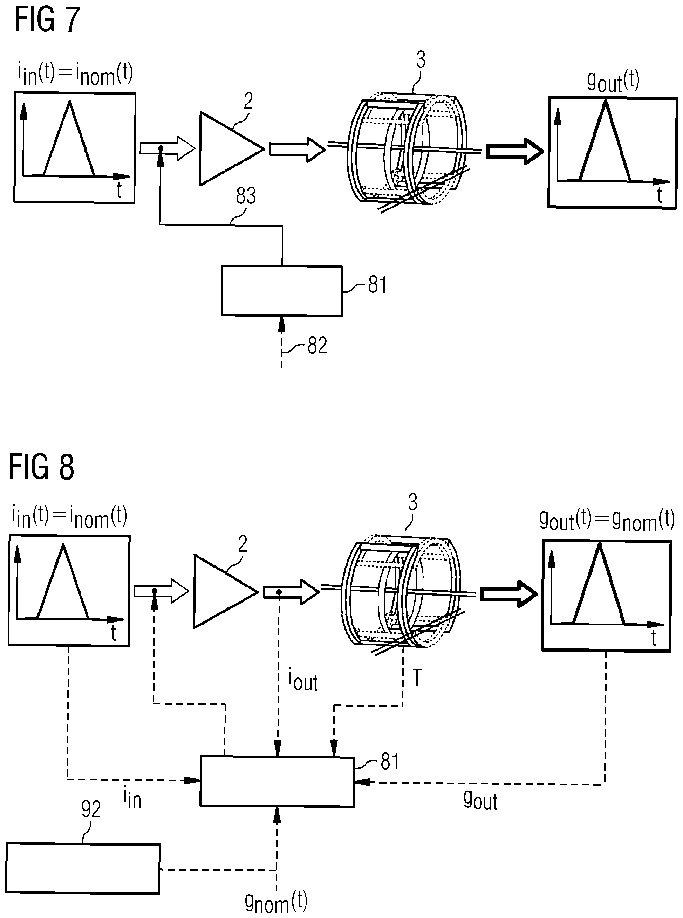

Figur 7 zeigt ein schematisches Blockdiagramm zur Erläuterung der Verwendung einer trainierten Funktion 81 zum Reduzieren und/oder Korrigieren von Abweichungen eines durch eine MR-Anlage 1 erzeugten Magnetfeldgradienten von einem Ziel-Gradienten. Die trainierte Funktion ist so konfiguriert, dass sie ein Eingangssignal 83 an den Verstärker 2 in Abhängigkeit von einem Ziel-Gradienten $g_{nom}(t)$ anpasst, welcher ein Eingangssignal 82 der trainierten Funktion 81 sein kann. Das Eingangssignal 82 der trainierten Funktion 81 kann auch einen gemessenen, ausgespielten Magnetfeldgradienten umfassen. Eine solche Konfiguration ist bereits gut geeignet, um Abweichungen des erzeugten Magnetfeldgradienten vom Ziel-Gradienten aufgrund linearer und nichtlinearer Einflüsse der beteiligten Komponenten, z.B. Verstärker 2 und Gradientenspule 3, zu kompensieren. Dies gilt insbesondere in Fällen, in denen Temperatureffekte vernachlässigt werden können oder müssen, wie dies bei kostengünstigen Systemen oder bei extrem schnellen Zyklen der Fall ist.

Figur 8 zeigt ein schematisches Blockdiagramm zur Erläuterung der Verwendung einer trainierten Funktion 81 zum Reduzieren und/oder Korrigieren von Abweichungen eines durch eine MR-Anlage 1 erzeugten Magnetfeldgradienten von einem Ziel-Gradienten gemäß einer weiteren Ausführungsform der Erfindung. Dabei ist die trainierte Funktion 81 so konfiguriert, dass die trainierte Funktion 81 das Verstärker-Eingangssignal $i_{in}$ in den Verstärker in Abhängigkeit von verschiedenen Parametern, z. B. einer Temperatur T der Gradientenspule und einer Patienteninformation 92, etwa Maße oder Gewicht des Patienten, korrigiert. Die trainierte Funktion 81 kann weiter ein Verstärker-Ausgangssignal $i_{out}$ und einen gemessenen ausgespielten Magnetfeldgradienten $g_{out}$ als Eingang empfangen.

Die trainierte Funktion 81 kann z.B. dazu trainiert sein, den gewünschten Ziel-Gradienten anhand des Ausgangssignals des Verstärkers 2 zu erkennen bzw. identifizieren, sodass eine oben beschriebene Korrektur durchgeführt werden kann.

Weiter kann vorgesehen sein, dass die trainierte Funktion 81 anhand des Ausgangssignals des Verstärkers 2 direkt eine Abweichung zum Ziel-Gradienten und/oder eine entsprechende Korrektur ermitteln kann.

Die trainierte Funktion 81 kann auch anhand des Eingangssignals des Verstärkers 2 den gewünschten Ziel-Gradienten ermitteln.

Das Eingangssignal 82 an die trainierte Funktion 81 kann auch eine beliebige Information sein, anhand derer sich der Ziel-Gradient identifizieren lässt, z.B. als ein numerischer Wert, ein String, ein Tupel, oder eine beliebige andere Datenstruktur verpackt. Das Eingangssignal 82 kann auch ein analoges Signal sein, etwa der Eingangsstrom des Verstärkers 2.

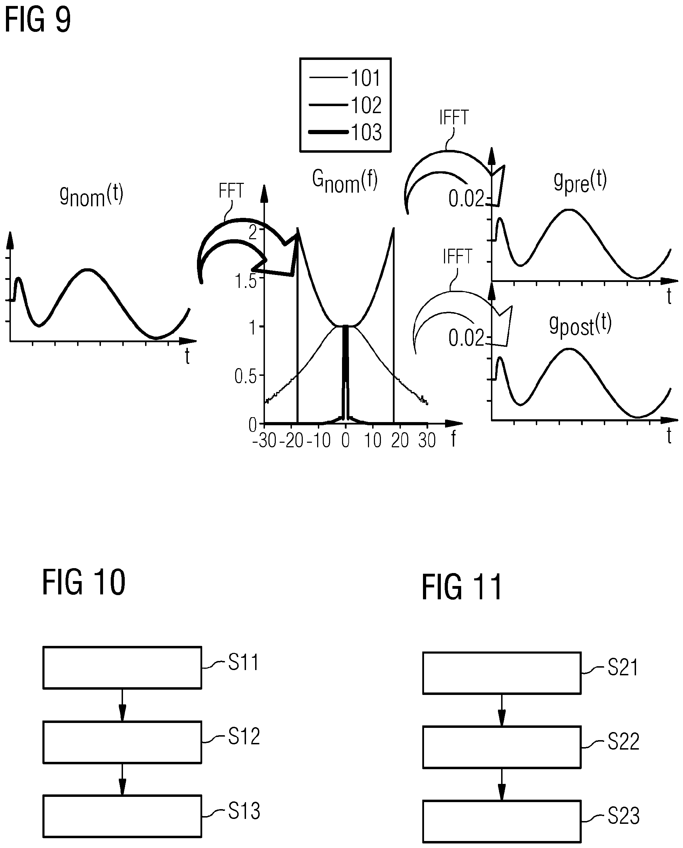

Figur 9 zeigt beispielhafte Darstellungen der Reduktion und/oder Korrektur von Abweichungen eines durch eine MR-Anlage 1 erzeugten Magnetfeldgradienten von einem Ziel-Gradienten für einen spezifischen Zeitverlauf des Ziel-Gradienten. Der Zeitverlauf ist hierbei spiralförmig. Gezeigt sind der Ziel-Gradient $g_{nom}(t)$, die durch Fouriertransformation FFT erhaltene Frequenzdarstellung 103 des Ziel-Gradienten $G_{nom}(f)$ sowie die Frequenzdarstellung 101 der GSTF und die Frequenzdarstellung 102 der inversen GSTF.

Bei der Nachkorrektur wird die Frequenzdarstellung 103 des Ziel-Gradienten $G_{nom}(f)$ mit der GSTF multipliziert, bevor das Ergebnis wieder in den Zeitbereich transformiert wird. Bei der Vorkorrektur (pre-emphasis) wird die Frequenzdarstellung 103 des Ziel-Gradienten $G_{nom}(f)$ mit der Frequenzdarstellung 102 der inversen GSTF multipliziert. Die durch inverse FFT erhaltenen Zeitverläufe $g_{pre}(t)$ und $g_{post}(t)$ bei Vorkorrektur bzw. Nachkorrektur sind im Wesentlichen identisch.

Figur 10 zeigt ein Flussdiagramm eines Verfahrens zum Reduzieren und/oder Korrigieren von Abweichungen eines durch eine MR-Anlage erzeugten Magnetfeldgradienten von einem Ziel-Gradienten. Das Verfahren kann insbesondere mit der in Figur 1 beschriebenen Vorrichtung 4 durchgeführt werden.

Dabei werden in einem Schritt S11 Eingangsdaten für eine mittels eines Machine-Learning-Algorithmus trainierte Funktion bereitgestellt. Die Eingangsdaten umfassen eine Information über den Ziel-Gradienten der MR-Anlage 1. Bei der Information über den Ziel-Gradienten kann es sich insbesondere um eine Bezeichnung des Ziel-Gradienten (z.B. ein numerischer Wert, String oder ein Bezeichner in einem beliebigen Datenformat), das Verstärker-Eingangssignal, oder Verstärker-Ausgangssignal oder dergleichen handeln. Es ist ebenso vorstellbar, dass die Information über den Ziel-Gradienten einen zeitlichen Verlauf des Ziel-Gradienten, eine Frequenz des Ziel-Gradienten, eine Pulsweite des Ziel-Gradienten und/oder eine Flankensteilheit des Ziel-Gradienten umfasst.

Vorzugsweise umfasst die trainierte Funktion 81 (der trainierte Algorithmus) ein künstliches neuronales Netz, z.B. ein mehrschichtiges neuronales Netz ("deep learning") oder ein Convolutional Neural Network. Für das Training des trainierten Algorithmus können verschiedene Techniken, z.B. überwachtes Lernen, nicht überwachtes Lernen oder verstärktes Lernen eingesetzt werden. Darüber hinaus kann ein auf Delta-Regeln basierender Ansatz, ein Backpropagation-Algorithmus oder ein Stochastic-Gradient-Descent (SGD)-Verfahren verwendet werden, z.B. zur Berechnung des Magnetfeldgradienten von Verlustfunktionen in Bezug auf die Gewichte des Netzes.

In einem weiteren Schritt S12 werden Ausgangsdaten mittels der trainierten Funktion anhand der Eingangsdaten erzeugt. Die trainierte Funktion kann dabei verschiedene Schichten (Layer) mit jeweiligen Neuronen aufweisen. Die Gewichte der Neuronen werden beim Trainieren derart eingelernt, dass die trainierte Funktion in der Lage ist, Ausgangsdaten zu erzeugen, welche zum Reduzieren und/oder Korrigieren der Abweichungen verwendet werden können.

In einem Schritt S13 werden Abweichungen des durch die MR-Anlage 1 erzeugten Magnetfeldgradienten von dem Ziel-Gradienten anhand der erzeugten Ausgangsdaten korrigiert und/oder reduziert.

Figur 11 zeigt ein Flussdiagramm eines computerimplementierten Verfahrens zum Erzeugen einer trainierten Funktion.

In einem ersten Schritt S21 werden Trainingsdaten bereitgestellt, welche mindestens einen Ziel-Gradienten einer MR-Anlage 1 mit zugehörigem tatsächlich durch die MR-Anlage 1 erzeugten Magnetfeldgradienten umfasst. Die Trainingsdaten können für ein Paar aus einem Ziel-Gradienten und einem zugehörigen tatsächlich durch die MR-Anlage 1 erzeugten Magnetfeldgradienten mindestens eines der Signale bzw. Daten umfassen, welche im Zusammenhang mit Figur 1 als Eingangsdaten der trainierten Funktion 81 beschrieben worden sind. Dadurch werden die jeweiligen Abhängigkeiten mit trainiert. Die trainierte Funktion 81 ist dann in der Lage, diese Abhängigkeiten zu berücksichtigen.

In einem zweiten Schritt S22 wird die Funktion mittels eines Machine-Learning-Algorithmus trainiert. Dabei werden die Trainingsdaten herangezogen. Die Funktion 81 wird trainiert, Ausgangsdaten auszugeben, welche zum Reduzieren und/oder Korrigieren von Abweichungen durch die MR-Anlage 1 erzeugter Magnetfeldgradienten von Ziel-Gradienten verwendbar sind.

Gemäß einer Ausführungsform wird die trainierte Funktion 81 derart erzeugt, dass anhand der trainierten Funktion 81 eine Schätzung für einen von der MR-Anlage 1 erzeugten Magnetfeldgradienten ermittelt werden kann. Anhand der Schätzung für den von der MR-Anlage 1 erzeugten Magnetfeldgradienten kann eine Gradientencharakterisierungsfunktion ermittelt werden. Anhand der Gradientencharakterisierungsfunktion kann ein korrigiertes Verstärker-Eingangssignal oder ein Korrektursignal zum Korrigieren des Verstärker-Eingangssignals erzeugt werden, d.h. zur Vorkorrektur.

Alternativ wird die trainierte Funktion 81 derart erzeugt, dass anhand von Rohdaten, welche von der MR-Anlage 1 mittels des erzeugten Magnetfeldgradienten erzeugt werden, und anhand der Gradientencharakterisierungsfunktion MR-Bilddaten erzeugt werden können, d.h. zur Nachkorrektur.

Die Trainingsdaten können eine Information über den Ziel-Gradienten der MR-Anlage 1 und zugehörige tatsächlich durch die MR-Anlage 1 erzeugte Magnetfeldgradienten für eine Vielzahl unterschiedlicher Temperaturen von mindestens einer Komponente der MR-Anlage 1, unterschiedlicher Frequenzen, unterschiedlicher Pulsweiten, unterschiedlicher Amplituden und/oder unterschiedlicher Flankensteilheiten umfassen.

In einem weiteren Schritt S23 wird die trainierte Funktion 81 bereitgestellt. Hierzu kann die trainierte Funktion 81 in einem Speicher einer Speichereinheit gespeichert werden bzw. von der Speichereinheit aus ausgeführt werden.

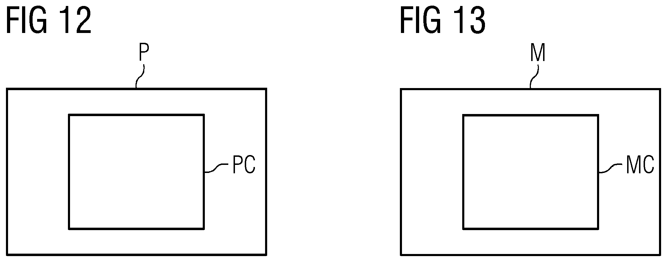

Figur 12 zeigt ein schematisches Blockdiagramm eines Computerprogrammprodukts P mit ausführbarem Programmcode PC. Der ausführbare Programmcode PC ist dazu ausgebildet, beim Ausführen auf einem Computer eines der oben beschriebenen Verfahren durchzuführen.

Figur 13 zeigt ein schematisches Blockdiagramm eines nichtflüchtigen, computerlesbaren Speichermediums M mit ausführbarem Programmcode MC, dazu ausgebildet, beim Ausführen auf einem Computer eines der oben beschriebenen Verfahren durchzuführen.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zum Reduzieren und/oder Korrigieren von Abweichungen eines durch eine Magnetresonanzanlage, MR-Anlage (1), erzeugten Magnetfeldgradienten von einem Ziel-Gradienten, wobei das Verfahren folgende Schritte umfasst:

   Bereitstellen (S11) von Eingangsdaten für eine mittels eines Machine-Learning-Algorithmus trainierte Funktion (81), wobei die Eingangsdaten eine Information über den Ziel-Gradienten der MR-Anlage (1) umfassen;
   Erzeugen (S12) von Ausgangsdaten mittels der trainierten Funktion (81) anhand der Eingangsdaten; und
   Reduzieren und/oder Korrigieren (S13) der Abweichungen des durch die MR-Anlage (1) erzeugten Magnetfeldgradienten von dem Ziel-Gradienten anhand der erzeugten Ausgangsdaten.

2. Verfahren nach Anspruch 1, wobei die MR-Anlage (1) einen Verstärker (2) umfasst, welcher ein Verstärker-Eingangssignal verstärkt und als Verstärker-Ausgangssignal ausgibt, und wobei die MR-Anlage (1) eine Gradientenspule (3) umfasst, welche anhand des Verstärker-Ausgangssignals den Magnetfeldgradienten erzeugt;

   wobei die trainierte Funktion (81) ein korrigiertes Verstärker-Eingangssignal oder ein Korrektursignal zum Korrigieren des Verstärker-Eingangssignals ermittelt; und
   wobei das Verstärker-Ausgangssignal in Abhängigkeit des korrigierten Verstärker-Eingangssignals oder des Korrektursignals erzeugt wird.

3. Verfahren nach Anspruch 1 oder 2, wobei die trainierte Funktion (81) eine Schätzung für einen von der MR-Anlage (1) erzeugten Magnetfeldgradienten ermittelt.

4. Verfahren nach Anspruch 3, wobei anhand der Schätzung für den von der MR-Anlage (1) erzeugten Magnetfeldgradienten eine Gradientencharakterisierungsfunktion ermittelt wird.

5. Verfahren nach Anspruch 4, wobei anhand der Gradientencharakterisierungsfunktion ein korrigiertes Verstärker-Eingangssignal oder ein Korrektursignal zum Korrigieren des Verstärker-Eingangssignals erzeugt wird; und
   wobei das korrigierte Verstärker-Eingangssignal an den Verstärker (2) angelegt wird.

6. Verfahren nach Anspruch 4 oder 5, wobei die MR-Anlage (1) mittels des erzeugten Magnetfeldgradienten Rohdaten erzeugt; und
   wobei anhand der Rohdaten und der Gradientencharakterisierungsfunktion MR-Bilddaten erzeugt werden.

7. Verfahren nach einem der vorangehenden Ansprüche, wobei die Eingangsdaten für die trainierte Funktion (81) weiter mindestens eines umfassen von

   - einem Verstärker-Eingangssignal eines Verstärkers (2) der MR-Anlage (1), wobei der Verstärker (2) das Verstärker-Eingangssignal verstärkt und als Verstärker-Ausgangssignal an eine Gradientenspule (3) der MR-Anlage (1) ausgibt, welche anhand des Verstärker-Ausgangssignals einen Magnetfeldgradienten erzeugt,
   - dem gemessenen Verstärker-Ausgangssignal,
   - mindestens einer gemessenen Temperatur des Verstärkers (2) und/oder der Gradientenspulen (3),
   - einem gemessenen von der MR-Anlage (1) erzeugten Magnetfeldgradienten,
   - einem Bildgebungsbereich, insbesondere einem diagnostisch relevanten Bildgebungsbereich, und
   - eine Information bezüglich eines durch die MR-Anlage (1) untersuchten Objekts.

8. Computerimplementiertes Verfahren zum Erzeugen einer trainierten Funktion (81), mit den Schritten:

   Bereitstellen (S21) von Trainingsdaten, welche mindestens eine Information über einen Ziel-Gradienten einer Magnetresonanzanlage, MR-Anlage (1), mit zugehörigem tatsächlich durch die MR-Anlage (1) erzeugtem Magnetfeldgradienten umfasst;
   Trainieren (S22) der Funktion (81) mittels eines Machine-Learning-Algorithmus, basierend auf den Trainingsdaten, wobei die Funktion (81) trainiert wird, Ausgangsdaten auszugeben, welche zum Reduzieren und/oder Korrigieren von Abweichungen durch die MR-Anlage (1) erzeugter Magnetfeldgradienten von Ziel-Gradienten verwendbar sind; und
   Bereitstellen (S23) der trainierten Funktion (81).

**9.** Verfahren nach Anspruch 8,

wobei die trainierte Funktion (81) derart erzeugt wird,
dass anhand der trainierten Funktion eine Schätzung für einen von der MR-Anlage (1) erzeugten Magnetfeldgradienten ermittelt werden kann, wobei anhand der Schätzung für den von der MR-Anlage (1) erzeugten Magnetfeldgradienten eine Gradientencharakterisierungsfunktion ermittelt werden kann, und
dass anhand der Gradientencharakterisierungsfunktion ein korrigiertes Verstärker-Eingangssignal oder ein Korrektursignal zum Korrigieren des Verstärker-Eingangssignals erzeugt werden kann, oder dass anhand von Rohdaten, welche von der MR-Anlage (1) mittels des erzeugten Magnetfeldgradienten erzeugt werden, und anhand der Gradientencharakterisierungsfunktion MR-Bilddaten erzeugt werden können.

**10.** Verfahren nach Anspruch 8 oder 9, wobei die Trainingsdaten eine Information über den Ziel-Gradienten der MR-Anlage (1) und zugehörige tatsächlich durch die MR-Anlage (1) erzeugte Magnetfeldgradienten für eine Vielzahl unterschiedlicher Temperaturen von mindestens einer Komponente der MR-Anlage (1), unterschiedlicher Frequenzen, unterschiedlicher Pulsweiten, unterschiedlicher Amplituden und/oder unterschiedlicher Flankensteilheiten umfassen.

**11.** Verfahren nach einem der Ansprüche 8 bis 10, wobei die Trainingsdaten für ein Paar aus einem Ziel-Gradienten und einem zugehörigen tatsächlich durch die MR-Anlage (1) erzeugten Magnetfeldgradienten weiter mindestens eines umfassen von

- einem Verstärker-Eingangssignal eines Verstärkers (2) der MR-Anlage (1), wobei der Verstärker (2) das Verstärker-Eingangssignal verstärkt und als Verstärker-Ausgangssignal an Gradientenspulen (3) der MR-Anlage (1) ausgibt, welche anhand des Verstärker-Ausgangssignals einen Magnetfeldgradienten erzeugen,
- dem Verstärker-Ausgangssignal,
- mindestens einer gemessenen Temperatur des Verstärkers (2) und/oder der Gradientenspulen (3),
- einem gemessenen von der MR-Anlage (1) erzeugten Magnetfeldgradienten,
- einem Bildbereich, und
- eine Information bezüglich eines durch die MR-Anlage (1) untersuchten Objekts.

**12.** Vorrichtung (4) zum Reduzieren und/oder Korrigieren von Abweichungen eines durch eine Magnetresonanzanlage, MR-Anlage (1), erzeugten Magnetfeldgradienten von einem Ziel-Gradienten, mit:

einer Recheneinrichtung (41), welche dazu ausgebildet ist, einer mittels eines Machine-Learning-Algorithmus trainierten Funktion (81) Eingangsdaten bereitzustellen, wobei die Eingangsdaten eine Information über den Ziel-Gradienten der MR-Anlage (1) umfassen, und mittels der trainierten Funktion (81) anhand der Eingangsdaten Ausgangsdaten zu erzeugen; und
einer Reduzier-/Korrektureinrichtung (42), welche dazu ausgebildet ist, anhand der Ausgangsdaten der trainierten Funktion (81) die Abweichungen des durch die MR-Anlage (1) erzeugten Magnetfeldgradienten von dem Ziel-Gradienten zu reduzieren und/oder zu korrigieren.

**13.** Magnetresonanzanlage (1), mit:

einem Verstärker (2), welcher dazu ausgebildet ist, ein Verstärker-Eingangssignal zu verstärken und als Verstärker-Ausgangssignal auszugeben;
einer Gradientenspule (3), welche dazu ausgebildet ist, anhand des Verstärker-Ausgangssignals einen Magnetfeldgradienten zu erzeugen; und
einer Vorrichtung (4) nach Anspruch 12, welche dazu ausgebildet ist, Abweichungen des durch die Gradientenspulen (3) erzeugten Magnetfeldgradienten von einem Ziel-Gradienten zu korrigieren und/oder zu reduzieren.

**14.** Computerprogrammprodukt (P) mit ausführbarem Programmcode (PC), welcher dazu ausgebildet ist, beim Ausführen auf einer Steuervorrichtung (4) der MR-Anlage (1) nach Anspruch 13 das Verfahren gemäß einem der Ansprüche 1 bis 11 auszuführen.

**15.** Nichtflüchtiges, computerlesbares Speichermedium (M) mit ausführbarem Programmcode (MC), welcher dazu ausgebildet ist, beim Ausführen auf einer Steuervorrichtung (4) der MR-Anlage (1) nach Anspruch 13 das Verfahren gemäß einem der Ansprüche 1 bis 11 auszuführen.

FIG 1

FIG 2

$g_{int}(t) = g_{nom}(t)$

$g_{out}(t)$

# FIG 3

31

32

FT

11

FT

$g_{nom_X}(t)$

$g_{real\_x}(t)$

33

34

GSTF$_{XX}$

$G_{nom_X}(f)$

$\div$

$G_{real\_x}(f)$

# FIG 4

44

45

43

t

t

t

FIG 5

FIG 6

## FIG 7

$i_{in}(t) = i_{nom}(t)$

$g_{out}(t)$

2

3

83

81

82

## FIG 8

$i_{in}(t) = i_{nom}(t)$

$g_{out}(t) = g_{nom}(t)$

2

3

$i_{out}$

T

81

$i_{in}$

$g_{out}$

92

$g_{nom}(t)$

## FIG 9

$g_{nom}(t)$

$G_{nom}(f)$

| | —101 |
| | —102 |
| | —103 |

FFT

IFFT

$g_{pre}(t)$

0.02

IFFT

0.02

$g_{post}(t)$

## FIG 10

S11

S12

S13

## FIG 11

S21

S22

S23

FIG 12

P

PC

FIG 13

M

MC

Europäisches Patentamt
European Patent Office
Office européen des brevets

**EUROPÄISCHER RECHERCHENBERICHT**

Nummer der Anmeldung

EP 22 17 1264

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 3 543 722 A1 (KONINKLIJKE PHILIPS NV [NL]) 25. September 2019 (2019-09-25) | 1-3,7,8, 11-15 | INV. G01R33/565 |
| A | * Absatz [0071] - Absatz [0098] * | 4-6 | G01R33/56 |
| X | HWANG SAN-CHAO ET AL: "Fast eddy current compensation by feedback linearization neural networks: Applications in diffusion-weighted echo planar imaging", CONCEPTS IN MAGNETIC RESONANCE PART B: MAGNETIC RESONANCE ENGINEERING, Bd. 29B, Nr. 1, 1. Februar 2006 (2006-02-01), Seiten 1-8, XP055969653, US ISSN: 1552-5031, DOI: 10.1002/cmr.b.20058 | 1,7-15 | |
| A | * Kurzzusammenfassung * <br> * Abschnitt "THEORY" * <br> * Abschnitt "MATERIALS AND METHODS" * | 4-6 | |
| A | S. JOHANNA VANNESJO ET AL: "Image reconstruction using a gradient impulse response model for trajectory prediction", MAGNETIC RESONANCE IN MEDICINE, Bd. 76, Nr. 1, 1. Juli 2016 (2016-07-01), Seiten 45-58, XP055357586, US ISSN: 0740-3194, DOI: 10.1002/mrm.25841 * Kurzzusammenfassung * * Abschnitt "METHODS" * | 1-15 | RECHERCHIERTE SACHGEBIETE (IPC) G01R G06N |
| A | DE 10 2020 209787 A1 (SIEMENS HEALTHCARE GMBH [DE]) 10. Februar 2022 (2022-02-10) * Abbildungen 5,11,12,13 * * Absatz [0048] - Absatz [0079] * | 1-15 | |

-/--

Der vorliegende Recherchenbericht wurde für alle Patentansprüche erstellt

| Recherchenort | Abschlußdatum der Recherche | Prüfer |
|---|---|---|
| München | 13. Oktober 2022 | Durst, Markus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

**EP 22 17 1264**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2021/272335 A1 (HUANG QIAOYING [US] ET AL) 2. September 2021 (2021-09-02) <br> * Abbildung 5 * <br> * Absatz [0053] – Absatz [0080] * <br> ----- | 1-15 | |
| A | WO 2020/217098 A2 (INSIGHTEC LTD) 29. Oktober 2020 (2020-10-29) <br> * Absatz [0063] * <br> ----- | 1-15 | |

RECHERCHIERTE
SACHGEBIETE (IPC)

Der vorliegende Recherchenbericht wurde für alle Patentansprüche erstellt

| Recherchenort | Abschlußdatum der Recherche | Prüfer |
|---|---|---|
| München | 13. Oktober 2022 | Durst, Markus |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

........................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 17 1264

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-10-2022

| Im Recherchenbericht angeführtes Patentdokument | Datum der Veröffentlichung | Mitglied(er) der Patentfamilie | Datum der Veröffentlichung |
|---|---|---|---|
| EP 3543722 A1 | 25-09-2019 | CN 112136056 A | 25-12-2020 |
| | | EP 3543722 A1 | 25-09-2019 |
| | | EP 3769099 A1 | 27-01-2021 |
| | | US 2021106251 A1 | 15-04-2021 |
| | | WO 2019179797 A1 | 26-09-2019 |
| DE 102020209787 A1 | 10-02-2022 | DE 102020209787 A1 | 10-02-2022 |
| | | US 2022043092 A1 | 10-02-2022 |
| US 2021272335 A1 | 02-09-2021 | KEINE | |
| WO 2020217098 A2 | 29-10-2020 | CN 114040706 A | 11-02-2022 |
| | | EP 3959530 A2 | 02-03-2022 |
| | | JP 2022529670 A | 23-06-2022 |
| | | US 2022196771 A1 | 23-06-2022 |
| | | WO 2020217098 A2 | 29-10-2020 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **DUYN et al.** Simple correction method for k-space trajectory deviations in MRI. *J. Magn. Reson.,* 1998, vol. 132, 150-153

- **CAMPBELL-WASHBURN et al.** Realtime distortion correction of spiral and echo planar images using the gradient system impulse response function. *Magn. Reson. Med.,* 2016, vol. 75, 2278-2285